# FASCICULE DE BREVET EUROPEEN

(11) **EP 3 336 904 B1**
(45) Date de publication et mention de la délivrance du brevet: **05.05.2021**
(21) Numéro de dépôt: 17207694.5
(22) Date de dépôt: 15.12.2017
(51) Int. Cl.: H01L 31/05, H01L 31/0465

(54) **PROCÉDÉ DE FABRICATION D'UN MODULE PHOTOVOLTAÏQUE ET MODULE PHOTOVOLTAÏQUE AINSI OBTENU**
HERSTELLUNGSVERFAHREN EINES FOTOVOLTAIKMODULS, UND SO ERHALTENES FOTOVOLTAIKMODUL
METHOD FOR MANUFACTURING A PHOTOVOLTAIC MODULE AND PHOTOVOLTAIC MODULE THUS OBTAINED

(30) Priorité: 16.12.2016 FR 1662616
(43) Date de publication de la demande: 20.06.2018
(73) Titulaire: ARMOR SOLAR POWER FILMS, 44100 Nantes (FR)
(72) Inventeur: BERTRAND, Mélanie, 44120 VERTOU (FR); ALLAIS, François, 44115 BASSE GOULAINE (FR); MWAURA, Jeremiah K., ANDOVER, MA 01810 (US)
(74) Mandataire: Lavoix

(56) Documents cités:
- WO-A1-2013/108623
- US-A1- 2012 276 681

## Description

La présente invention concerne un procédé de fabrication d'un module photovoltaïque, du type comprenant au moins deux cellules photovoltaïques connectées électriquement, le procédé comprenant les étapes suivantes : fourniture d'un substrat électriquement isolant recouvert d'une couche d'un premier matériau électriquement conducteur ; puis formation, sur ladite couche, d'au moins un sillon définissant une première et une deuxième électrodes inférieures, électriquement isolées l'une de l'autre par ledit sillon ; puis formation, sur chacune desdites électrodes inférieures, d'un empilement comprenant au moins : une électrode supérieure formée d'une couche d'un deuxième matériau électriquement conducteur ; et une couche d'un matériau photo-actif disposée entre les électrodes inférieure et supérieure, chacune des première et deuxième électrodes inférieures formant respectivement une première et une deuxième cellules photovoltaïques avec l'empilement correspondant ; puis formation d'une connexion électrique entre l'électrode supérieure de la première cellule photovoltaïque et la deuxième électrode inférieure.

Un module photovoltaïque est un composant électronique qui, exposé à la lumière, produit de l'électricité. Un tel module photovoltaïque comprend typiquement plusieurs cellules photovoltaïques connectées électriquement. Chaque cellule comporte au moins un matériau photo-actif, c'est-à-dire apte à produire de l'électricité à partir de la lumière. Un tel matériau est par exemple un semi-conducteur organique.

Un module photovoltaïque du type précité est décrit dans les documents US 7,932,124 B2, US 2012/276681 A1, WO 2013/108623 A1 et US 4,243,432 A. Chaque cellule d'un tel module photovoltaïque est formée d'un empilement de bandes, comportant une couche photo-active entre deux électrodes, ledit empilement de bandes étant disposé sur un support.

Un tel empilement, dit zone active, est séparé des zones actives voisines par une zone dite inactive. Ladite zone inactive permet d'isoler électriquement les électrodes inférieures de deux cellules voisines tout en reliant l'électrode supérieure de chaque cellule à l'électrode inférieure d'une cellule voisine. Un module photovoltaïque est obtenu par la formation de plusieurs cellules ainsi connectées en série.

Généralement, dans les méthodes de production à grande échelle, les couches des empilements sont réalisées par voie humide, c'est-à-dire par dépôt d'une formulation liquide suivie d'un passage à l'état solide.

La performance du module photovoltaïque passe notamment par la réalisation de zones inactives les plus étroites possibles, pour maximiser la taille des zones actives. Cependant, les propriétés rhéologiques et de mouillabilité des formulations, ainsi que les propriétés physiques des supports, imposent des largeurs minimales pour les zones inactives. En particulier, les dépôts par voie humide induisent des effets de bords sur les bandes.

Les couches de l'empilement formant chaque cellule dans le document US7932124 sont notamment réalisées avec des largeurs décroissantes, de sorte à ménager un décalage latéral en marches d'escalier. Un tel procédé de réalisation complexifie sa mise en œuvre par des méthodes de production à grande échelle et contribue à diminuer la taille des zones actives.

La présente invention a pour but de proposer un procédé de fabrication d'un module photovoltaïque permettant notamment de minimiser la taille des zones inactives et de maximiser celle des zones actives. Ceci est résolu par la méthode selon la revendication 1. D'autres aspects avantageuses de l'invention sont données dans les revendications dépendantes.

A cet effet, l'invention a pour objet un procédé de fabrication du type précité, comprenant les étapes suivantes, entre l'étape de formation du sillon et celle de l'empilement : formation d'une première bande électriquement isolante dans le sillon et par-dessus ledit sillon, ladite bande formant un relief par rapport aux première et deuxième électrodes inférieures ; et formation d'une deuxième bande électriquement isolante sur la deuxième électrode inférieure, lesdites première et deuxième bandes électriquement isolantes étant sensiblement parallèles et délimitant une zone inactive sur ladite deuxième électrode inférieure. De plus, l'empilement formé sur la deuxième cellule photovoltaïque est disposé en dehors de la zone inactive.

Suivant d'autres aspects avantageux de l'invention, le procédé comporte l'une ou plusieurs des caractéristiques suivantes, prises isolément ou suivant toutes les combinaisons techniquement possibles :
- une largeur de la zone inactive est comprise entre 0,1 mm et 2 mm ;
- le procédé comprend en outre, entre l'étape de formation du sillon et celle de l'empilement, l'étape suivante : formation d'une troisième bande électriquement isolante sur la première électrode inférieure, les première et troisième bandes électriquement isolantes étant sensiblement parallèles, l'empilement formé ensuite sur la première électrode inférieure étant disposé entre lesdites première et troisième bandes électriquement isolantes.
- au moins la première bande électriquement isolante est formée par dépôt, sur le sillon et sur le premier matériau électriquement conducteur, d'une première formulation liquide de matériau isolant, suivi d'un passage à l'état solide de ladite première formulation ;
- la couche du premier matériau électriquement conducteur recouvrant le substrat présente une première énergie de surface ; et le dépôt de la première formulation liquide crée une première interface avec ledit premier matériau électriquement conducteur, la première tension de surface de ladite première interface étant inférieure à ladite première énergie de surface ; une différence entre ladite première énergie de surface et ladite première tension de surface étant préférentiellement comprise entre 0,015 N.m⁻¹ et 0,025 N.m⁻¹ ;
- l'étape de formation d'une connexion électrique comprend le dépôt d'une couche d'un troisième matériau électriquement conducteur entre l'électrode supérieure de la première cellule photovoltaïque et la deuxième électrode inférieure de la deuxième cellule photovoltaïque, par-dessus la première bande électriquement isolante ;
- la première bande électriquement isolante présente une deuxième énergie de surface ; et la couche de troisième matériau électriquement conducteur est formée par dépôt d'une deuxième formulation liquide, créant une deuxième interface avec ladite première bande électriquement isolante, une deuxième tension de surface de ladite deuxième interface étant inférieure à ladite deuxième énergie de surface ; une différence entre ladite deuxième énergie de surface et ladite deuxième tension de surface étant préférentiellement supérieure à 0,015 N.m⁻¹ ;
- la première formulation liquide de matériau isolant comprend au moins un polymère et au moins un tensio-actif, l'au moins un polymère étant préférentiellement préparé à base de composés choisis parmi les amines, les acrylates, les époxydes, les uréthanes et leurs mélanges, et l'au moins un tensio-actif étant préférentiellement un composé fluoré ;
- au moins l'une des couches de deuxième matériau électriquement conducteur et de matériau photo-actif est formée par une technique d'enduction ou d'impression au déroulé par voie humide, préférentiellement choisie parmi le slot-die, l'héliogravure, la flexographie et la sérigraphie rotative ;
- l'étape de formation d'une connexion électrique est réalisée simultanément au dépôt de la couche du deuxième matériau électriquement conducteur, le troisième matériau électriquement conducteur étant identique audit deuxième matériau électriquement conducteur.
- l'électrode supérieure et la connexion électrique sont formées d'un matériau électriquement conducteur transparent à la lumière visible ;
- une épaisseur de la couche de troisième matériau électriquement conducteur est inférieure à 1 µm et préférentiellement inférieure à 600 nm.

L'invention se rapporte en outre à un module photovoltaïque selon la revendication 11 issu d'un procédé selon l'une des revendications 1 à 10, au moins la première bande électriquement isolante étant formée par dépôt, sur le sillon et sur le premier matériau électriquement conducteur, d'une première formulation liquide de matériau isolant, suivi d'un passage à l'état solide de ladite première formulation. Une épaisseur de la couche de troisième matériau électriquement conducteur étant inférieure à 5 µm.

Suivant un aspect avantageux de l'invention, ledit module est tel qu'un ratio entre la somme d'aires des empilements comprenant une couche de matériau photo-actif et une aire totale du substrat est supérieur à 80% et préférentiellement supérieur à 85%.

L'invention sera mieux comprise à la lecture de la description qui va suivre, donnée uniquement à titre d'exemple non limitatif et faite en se référant aux dessins sur lesquels :
- la figure 1 est une vue schématique, en coupe, d'un module photovoltaïque selon un mode de réalisation de l'invention ;
- la figure 2 est une vue de détail du module photovoltaïque de la figure 1 ; et
- les figures 3 à 6 représentent schématiquement des étapes de fabrication du module photovoltaïque de la figure 1, par un procédé selon un mode de réalisation de l'invention.

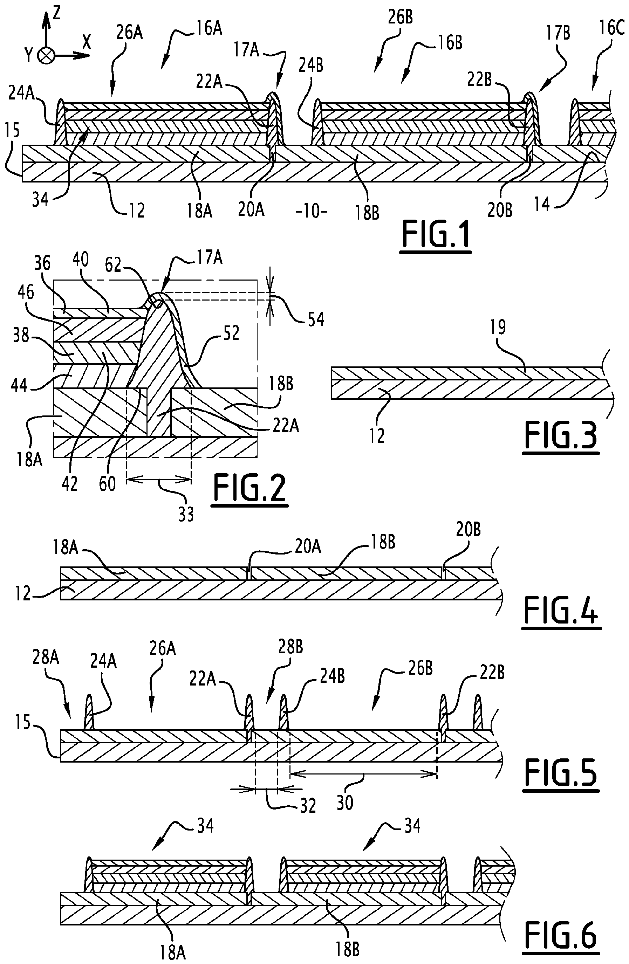

La figure 1 représente une vue en coupe d'un module photovoltaïque 10 selon un mode de réalisation de l'invention.

Le module photovoltaïque 10 comporte notamment un substrat 12, formé d'un film de matériau électriquement isolant et transparent à la lumière visible, notamment de type polymère. Le substrat 12 comporte notamment une surface 14 sensiblement plane, délimitée par au moins un bord 15.

On considère une base orthonormée (X, Y, Z), la surface 14 formant un plan (X, Y).

Le module photovoltaïque 10 comporte au moins deux cellules photovoltaïques 16A, 16B, 16C, disposées sur le substrat 12. Le module photovoltaïque 10 comporte en outre au moins une connexion électrique 17A, 17B entre deux cellules photovoltaïques.

Chacune des cellules photovoltaïques 16A, 16B, 16C est formée par l'empilement de bandes enduites longitudinalement selon la direction Y. Une longueur des bandes selon Y peut aller jusqu'à plusieurs centaines de mètres.

De préférence, le module photovoltaïque 10 comporte une pluralité de cellules photovoltaïques 16A, 16B, 16C, par exemple un nombre de cellules photovoltaïques supérieur à trois. Le module photovoltaïque 10 comporte préférentiellement quatre, neuf ou vingt cellules photovoltaïques en forme de bandes, le nombre de cellules n'étant pas contraint à ces seules valeurs.

Les cellules photovoltaïques 16A, 16B, 16C sont sensiblement identiques et adjacentes selon la direction X. Les cellules adjacentes sont reliées par une connexion électrique 17A, 17B.

Une première cellule photovoltaïque 16A est adjacente selon X à un bord 15 du substrat 12. Une deuxième cellule photovoltaïque 16B est disposée entre la première 16A et une troisième 16C cellules photovoltaïques. Ladite deuxième cellule 16B est connectée électriquement à chacune desdites première 16A et troisième 16C cellules, respectivement par une première 17A et par une deuxième 17B connexions électriques.

Les première 16A et deuxième 16B cellules photovoltaïques seront décrites simultanément ci-après. La troisième cellule photovoltaïque 16C, partiellement représentée sur la figure 1, est considérée comme identique à la deuxième cellule photovoltaïque 16B.

Chaque cellule photovoltaïque 16A, 16B comporte une électrode inférieure 18A, 18B, au contact de la surface 14 du substrat 12. L'électrode inférieure 18A, 18B est formée d'une couche d'un premier matériau électriquement conducteur 19, transparent à la lumière visible. A titre indicatif, l'électrode inférieure 18A, 18B présente une largeur selon X comprise entre 10 mm et 20 mm.

Chaque électrode inférieure 18A, 18B est séparée de la ou des deux électrodes inférieures adjacentes par un sillon 20A, 20B s'étendant selon Y. Par exemple, les première 18A et deuxième 18B électrodes inférieures des première 16A et deuxième 16B cellules photovoltaïques sont séparées par le sillon 20A ; la deuxième électrode inférieure 18B est délimitée selon X par les sillons 20A et 20B.

Un fond du sillon 20A, 20B est formé par le substrat 12 électriquement isolant. Ainsi, chaque sillon 20A, 20B isole électriquement les électrodes inférieures situées de part et d'autre dudit sillon.

Les électrodes inférieures 18A, 18B ont une épaisseur selon Z préférentiellement inférieure à 1 µm. Plus préférentiellement, ladite épaisseur est comprise entre 50 et 500 nm.

Chaque cellule photovoltaïque 16A, 16B comporte en outre une première 22A, 22B et une deuxième 24A, 24B bandes électriquement isolantes, s'étendant selon Y. Chacune desdites bandes électriquement isolantes forme un relief selon Z par rapport aux électrodes inférieures 18A, 18B.

Chaque première bande électriquement isolante 22A, 22B s'étend dans un sillon 20A, 20B et par-dessus ledit sillon. Chaque deuxième bande électriquement isolante 24A, 24B s'étend à distance des sillons 20A, 20B. Ainsi, chaque deuxième bande électriquement isolante 24A, 24B sépare l'électrode inférieure 18A, 18B correspondante en deux zones 26A, 26B et 28A, 28B, adjacentes selon X.

Une première zone 26A, 26B est dite « zone active » et une deuxième zone 28A, 28B est dite « zone inactive ». Sur la figure 1, chacune des zones actives 26A et 26B, respectivement des première 16A et deuxième 16B cellules photovoltaïques, est respectivement comprise entre la première bande 22A et la deuxième bande 24A, et entre la première bande 22B et la deuxième bande 24B.

La zone inactive 28B (figure 5) de la deuxième cellule photovoltaïque 16B est comprise entre la première bande 22A, séparant les première 16A et deuxième 16B cellules photovoltaïques, et la deuxième bande 24B. La zone inactive 28A de la première cellule photovoltaïque 16A est comprise entre le bord 15 du substrat 12 et la deuxième bande 24A.

Une largeur 30 selon X de la zone active 26A, 26B (figure 5) est supérieure à une largeur 32 selon X de la zone inactive 28A, 28B. De préférence, la largeur 32 de la zone inactive 28B de la deuxième cellule photovoltaïque 16B est comprise entre 0,1 mm et 2,0 mm, plus préférentiellement comprise entre 0,5 mm et 1,5 mm. De préférence, les largeurs 30 des zones actives 26A et 26B des cellules photovoltaïques 16B et 16B sont comprises entre 10 mm et 15 mm, plus préférentiellement comprises entre 11 mm et 14 mm.

A titre indicatif, une largeur 33 (figure 2) selon X de chaque bande électriquement isolante 22A, 22B, 24A, 24B est comprise entre 0,2 mm et 1 mm.

Au niveau de la zone active 26A, 26B, chaque cellule photovoltaïque 16A, 16B comporte un empilement 34 de couches de matériaux. L'empilement 34, ou zone active, comprend au moins une électrode supérieure 36 et une couche photo-active 38.

L'électrode supérieure 36 est formée d'une couche d'un deuxième matériau électriquement conducteur 40, notamment métallique, préférentiellement transparent à la lumière visible. Il s'agit par exemple d'une encre à base de nanoparticules d'argent ou de nanofils d'argent.

La couche photo-active 38, disposée entre les électrodes inférieure 18A, 18B et supérieure 36, est constituée d'un matériau photo-actif 42. Le matériau photo-actif 42 est de nature semi-conducteur. Il s'agit de préférence d'un semi-conducteur organique. Avantageusement, le matériau photo-actif 42 est constitué d'un mélange d'un matériau donneur d'électrons, dit matériau de type p, et d'un matériau accepteur d'électrons, dit matériau de type n. Le matériau photo-actif 42 est par exemple un mélange intime, à l'échelle nanométrique, desdits matériaux de type p et n. Alternativement, la couche photo-active 38 peut être une hétérojonction d'un matériau de type p et d'un matériau de type n, sous la forme d'une couche ou d'un empilement de plusieurs couches.

Dans le mode de réalisation de la figure 1, la zone active 34 comporte en outre une première 44 et une deuxième 46 couches d'interface, ayant un rôle de transport d'électrons ou de trous entre les électrodes 18A, 18B, 36 et la couche photo-active 38. Chaque couche d'interface 44, 46 est disposée entre ladite couche photo-active 38 et l'une des électrodes inférieure 18A, 18B ou supérieure 36.

Chacune des différentes couches de la zone active 34 a préférentiellement une épaisseur selon Z inférieure à 5 µm, plus préférentiellement inférieure à 1 µm.

On considère le facteur de remplissage géométrique, ou GFF (*Geometric Fill-Factor*) du module photovoltaïque 10. Le GFF est défini comme un ratio entre la somme des aires des zones actives 34 des cellules photovoltaïques 16A, 16B, 16C et une aire totale du substrat 12. Plus le GFF est élevé, plus le module photovoltaïque 10 est électriquement performant.

L'obtention d'un GFF élevé impose notamment de maîtriser la géométrie des connexions électriques 17A, 17B, comme décrit ci-après.

La première connexion électrique 17A relie l'électrode supérieure 36 de la première cellule photovoltaïque 16A et la deuxième électrode inférieure 18B. Une vue de détail du module photovoltaïque 10, au niveau de ladite première connexion électrique 17A, est représentée sur la figure 2.

La première connexion électrique 17A est formée par une couche d'un troisième matériau électriquement conducteur 52. Ladite couche est disposée par-dessus la première bande électriquement isolante 22A et relie électriquement l'électrode supérieure 36 de la première cellule photovoltaïque 16A et la zone inactive 28B de la deuxième électrode inférieure 18B.

De préférence, une épaisseur 54 de ladite couche du matériau 52 est sensiblement homogène le long du dénivelé formé par la première bande électriquement isolante 22A. En effet, une épaisseur trop variable peut induire l'interruption de la connectivité électrique entre deux cellules voisines.

Ladite épaisseur 54 est inférieure à 5 µm, plus préférentiellement inférieure à 1 µm et encore plus préférentiellement inférieure à 600 nm.

De préférence, le troisième matériau électriquement conducteur 52 est sensiblement identique au deuxième matériau électriquement conducteur 40.

La deuxième connexion électrique 17B est disposée de manière analogue à la première connexion électrique 17A, entre les deuxième 16B et troisième 16C cellules photovoltaïques.

Un procédé de fabrication du module photovoltaïque 10 ci-dessus va maintenant être décrit, sur la base des figures 3 à 6 :
Tout d'abord (figure 3) est fourni le substrat 12 recouvert d'une couche du premier matériau électriquement conducteur 19. Ledit matériau 19 est par exemple déposé sur la surface 14 du substrat 12 par enduction de type pleine surface.

Les sillons 20A, 20B sont ensuite formés sur ladite couche de matériau 19 (figure 4), notamment par gravure mécanique ou laser. Lesdits sillons définissent les électrodes inférieures 18A, 18B électriquement isolées les unes des autres.

Les premières 22A, 22B et les deuxièmes 24A, 24B bandes électriquement isolantes sont ensuite formées (figure 5) sur lesdites électrodes inférieures 18A, 18B, définissant les zones actives 26A, 26B et les zones inactives 28A, 28B. Comme il sera décrit ultérieurement, les bandes électriquement isolantes sont formées par dépôt d'une formulation liquide de matériau isolant, suivi d'un passage à l'état solide de ladite formulation.

Chacune des premières 22A, 22B bandes électriquement isolantes permet d'achever l'isolation électrique entre les cellules photovoltaïques adjacentes. En effet, la formation d'une bande électriquement isolante dans un sillon 20A, 20B permet de minimiser les courts-circuits éventuels entre les électrodes inférieures 18A, 18B voisines. De tels courts-circuits sont notamment induits par des débris générés lors de la formation du sillon par gravure.

Un empilement 34 de couches de matériaux est ensuite réalisé (figure 6) au niveau de la zone active 26A, 26B de chaque électrode inférieure 18A, 18B. Chaque couche peut être formée grâce à une large gamme de techniques. Les méthodes de fabrication compatibles avec la production à grande échelle sont de préférence des procédés continus tels que les procédés au déroulé ou roll-to-roll.

Les procédés au déroulé par voie humide, c'est-à-dire de dépôt à l'état liquide, sont divisés en différentes catégories : les méthodes d'impression permettent de créer des motifs à haute résolution ; les méthodes d'enduction comprennent un dépôt de matière en pleine laize ou pleine surface, sans motif.

Les méthodes d'impression comprennent notamment la flexographie, l'héliographie, l'héliogravure, l'impression offset, la sérigraphie et l'impression jet d'encre. Les méthodes d'enduction comprennent notamment l'enduction à filière plate communément appelée slot-die, l'enduction à rideau communément appelée curtain coating, et l'enduction à la racle communément appelée knife coating.

Chacune des différentes couches 36, 38, 44, 46 des empilements 34 est de préférence formée par une technique d'enduction ou d'impression au déroulé par voie humide, notamment choisie parmi le slot-die, l'héliogravure, la sérigraphie et la flexographie.

Les bandes électriquement isolantes forment une frontière physique entre les zones active et inactive de chaque électrode inférieure. Cette frontière facilite la formation des empilements 34 par couches successives, en contrôlant la définition des bords desdites couches. En particulier, la présence des bandes électriquement isolantes permet d'éviter le décalage latéral des couches, en marches d'escalier, tel que décrit dans le document US7932124.

Dans le cas d'impression ou d'enduction par des machines comportant des rouleaux d'entraînement, comme pour la flexographie, l'héliographie, l'héliogravure, la sérigraphie et le slot-die, les bandes électriquement isolantes forment aussi une protection physique selon l'axe Z de la surface enduite. Une telle protection permet de limiter la formation de défauts sur les différentes couches enduites, par le contact entre les rouleaux d'entraînement et le substrat à enduire.

Les différentes cellules photovoltaïques 16A, 16B, 16C sont ainsi obtenues. Lesdites cellules photovoltaïques sont électriquement isolées les unes des autres, comme visible sur la figure 6.

Une dernière étape du procédé de fabrication comprend la formation des connexions électriques 17A, 17B, en déposant une couche du troisième matériau électriquement conducteur 52 par-dessus les premières bandes électriquement isolantes 22A, 22B.

Le module photovoltaïque 10 de la figure 1 est ainsi obtenu.

De préférence, la formation des connexions électriques 17A, 17B et le dépôt de la couche 36 sont réalisés simultanément. Dans ce cas, le troisième matériau électriquement conducteur 52 est identique au deuxième matériau électriquement conducteur 40. Préférentiellement, une épaisseur 54 dudit troisième matériau est alors sensiblement identique à l'épaisseur de la couche 36.

Le troisième matériau électriquement conducteur 52 est de préférence obtenu par une technique d'enduction ou d'impression au déroulé par voie humide, c'est-à-dire par le dépôt d'une formulation liquide, suivi d'un passage à l'état solide de ladite formulation. Lors de cette étape, il est souhaitable d'obtenir une épaisseur 54 la plus faible possible, notamment de l'ordre de 1 µm, pour minimiser le contact humide de ladite formulation avec la couche précédemment déposée. En effet, un tel contact peut conduire à la redissolution des couches inférieures et la diffusion des solvants et des matériaux au travers des couches inférieures. Il en résulte des résistances parasites et des courts-circuits électriques.

De plus, une épaisseur 54 faible permet de limiter les effets de bord avec les première 22A et deuxième 24B bandes électriquement isolantes, lors de l'enduction par voie humide de la connexion électrique 17A. On peut ainsi minimiser la largeur 32 des zones inactives 28B des cellules photovoltaïques, ce qui conduit à une optimisation du GFF.

Par ailleurs, comme indiqué précédemment, il est souhaitable d'obtenir une épaisseur 54 homogène au niveau du dénivelé généré par la bande isolante afin d'assurer la continuité de la conductivité électrique. Or, les procédés de dépôt au déroulé classiques tels que le slot-die, l'héliogravure ou la flexographie, sont souvent inadaptés à l'obtention d'une épaisseur homogène sur des surfaces non planes telles que les bandes isolantes.

Des procédés de revêtement en phase gazeuse, tels que les procédés chimiques ou physiques de dépôt par évaporation, sont connus pour permettre l'obtention d'une couche d'épaisseur homogène sur des surfaces non planes. De tels procédés sont cependant peu compatibles avec la production industrielle de modules photovoltaïques de grandes surfaces, notamment car ils génèrent beaucoup de perte de matière.

Des méthodes de sérigraphie, qui permettent d'enduire des encres à base de particules métalliques d'argent, sont également connues. Cependant, l'homogénéité est établie par des épaisseurs enduites généralement supérieures à 5 µm, ce qui est trop élevé par rapport aux épaisseurs 54 visées.

Selon un mode préférentiel de réalisation de l'invention, le procédé de formation de la couche du troisième matériau électriquement conducteur 52 permet de contrôler la valeur et l'homogénéité de l'épaisseur 54. Ledit procédé implique la maîtrise des tensions superficielles des différentes formulations déposées à l'état liquide.

La tension superficielle est définie comme l'énergie nécessaire pour modifier la forme d'une interface établie entre les molécules d'un premier liquide et celles d'un deuxième liquide ou d'une substance gazeuse insoluble dans le premier liquide. La tension superficielle se mesure en newtons par mètre (N.m⁻¹). La tension superficielle d'un liquide sur un support solide, ou tension de surface, peut être mesurée grâce à un tensiomètre ou goniomètre. La tension est déterminée à l'aide d'une sonde idéale, permettant un mouillage parfait quels que soient les liquides étudiés, ladite sonde étant suspendue à une balance de précision.

L'absence de mobilité des molécules d'un solide ne permet pas, comme pour un liquide, la détermination directe de sa tension de surface. La tension superficielle d'un solide, ou énergie de surface, peut être mesurée indirectement par la mesure des angles de contact avec différents liquides de référence. Les angles de contact permettent de modéliser l'angle que forme, avec une surface donnée, une goutte de trois liquides purs standards possédant une partie dispersive et une partie polaire. Les liquides de référence utilisables sont notamment le thiodiglycol, l'éthylène glycol et le diiodométhane

Selon le mode préférentiel de réalisation du procédé décrit précédemment, la première bande isolante 22A est réalisée par enduction d'une première formulation liquide de matériaux isolants sur les électrodes inférieures 18A, 18B et le sillon 20A, suivie d'un séchage. Ladite première formulation comprend par exemple des polymères préparés à partir de matériaux tels que des aminés, des acrylates, des époxydes, des uréthanes, des phénoxys ou des combinaisons de ceux-ci. Ces matériaux isolants sont déposés en solution, ou encore sans solvant lorsqu'ils sont à l'état liquide à température ambiante.

La couche du premier matériau électriquement conducteur 19 recouvrant le substrat 12 présente une première énergie de surface γ_{S1}. Le dépôt de la première formulation liquide crée une première interface 60 (figure 2) avec ledit premier matériau 19. Ladite première interface présente une première tension de surface T_{S1}, inférieure à la première énergie de surface γ_{S1}. De préférence, une différence entre ladite première tension de surface T_{S1} et ladite première énergie de surface γ_{S1} est comprise entre 0,015 N.m⁻¹ et 0,025 N.m⁻¹.

La première formulation est alors solidifiée par séchage thermique pour former la première bande isolante 22A. A l'état solide, ladite première bande présente une deuxième énergie de surface γ_{S2}.

Après réalisation de l'empilement ou zone active 34, le troisième matériau électriquement conducteur 52 est déposé sous forme d'une deuxième formulation liquide. Ladite deuxième formulation liquide comporte au moins un matériau conducteur, qui peut être choisi parmi : les métaux et alliages électriquement conducteurs, notamment l'or, l'argent, le cuivre, l'aluminium, le nickel, le palladium, le platine et le titane ; les polymères conducteurs tels que les polythiophènes, les polyanilines, les polypyrroles ; et les oxydes métalliques tels que l'oxyde d'indium et d'étain, l'oxyde d'étain fluoré, l'oxyde d'étain et l'oxyde de zinc.

Le dépôt de la deuxième formulation liquide crée une deuxième interface 62 avec la première bande isolante 22A. Une deuxième tension de surface T_{S2} de ladite deuxième interface est inférieure à la deuxième énergie de surface γ_{S2}. De préférence, une différence entre ladite deuxième énergie de surface γ_{S2} et ladite deuxième tension de surface T_{S2} est supérieure à 0,015 N.m⁻¹.

La deuxième formulation est alors solidifiée par séchage thermique pour former la première connexion électrique 17A, sous forme d'une couche de matériau 52.

Le maintien des énergies de surface γ_{S1}, γ_{S2} et des tensions de surface T_{S1}, T_{S2} dans les plages décrites ci-dessus peut être obtenu en incorporant au moins un additif de type tensio-actif dans la première formulation liquide de matériaux isolants. Le choix du tensio-actif est déterminé par sa capacité à réduire la tension de surface T_{S1} de la première formulation liquide sans diminuer l'énergie de surface γ_{S2} de la bande solide formée après séchage.

L'additif de type tensio-actif est de préférence un agent tensio-actif fluoré et plus préférentiellement un agent tensio-actif fluoré non ionique éthoxylé.

Le maintien des énergies de surface γ_{S1}, γ_{S2} et des tensions de surface T_{S1}, T_{S2} dans les plages décrites ci-dessus permet d'obtenir une épaisseur 54 sensiblement homogène et inférieure ou égale à 1 µm. Le mode préférentiel de réalisation décrit ci-dessus permet notamment de minimiser la largeur 32 des zones inactives 28B des cellules photovoltaïques. Un GFF supérieur à 80%, voire supérieur à 85%, peut notamment être obtenu pour le module photovoltaïque 10.

Les exemples suivants illustrent l'invention sans en limiter la portée :

### Exemple 1 : formation de la première bande isolante 22A

Le substrat 12 est un film plastique de polyéthylène téréphtalate. Les électrodes inférieures 18A, 18B sont formées par dépôt sur ledit substrat d'une fine couche d'oxyde d'indium dopé à l'étain (ITO) en tant que premier matériau électriquement conducteur 19, puis par gravure des sillons 20A, 20B.

La première énergie de surface γ_{S1} des électrodes inférieures 18A, 18B est mesurée grâce à un goniomètre, les 3 liquides de référence étant le diiodométhane, l'éthylène glycol et le thiodiglycol. La première énergie de surface γ_{S1} ainsi mesurée est comprise entre 38 et 45 mN/m.

En parallèle, la première formulation liquide est préparée pour la réalisation de la première bande isolante 22A. Plusieurs exemples de formulations E, F, G et H sont présentées dans le tableau 1 ci-dessous :

**Tableau 1**

| | **Formulation E** | | **Formulation F** | | **Formulation G** | | **Formulation H** | |
|---|---|---|---|---|---|---|---|---|
| **Composé** | **Masse [g]** | % | **Masse [g]** | % | **Masse [g]** | % | **Masse [g]** | % |
| résine phenoxy | 2,379 | **23,79** | 2,378 | **23,78** | 2,378 | **23,78** | 2,373 | **23,73** |
| réticulant isocyanate | 0,097 | **0,97** | 0,097 | **0,97** | 0,097 | **0,97** | 0,097 | **0,97** |
| butan-2-one | 7,519 | **75,19** | 7,515 | **75,15** | 7,515 | **75,15** | 7,500 | **75,00** |
| tensio-actif A | 0,005 | **0,05** | 0,010 | **0,10** | - | **-** | - | **-** |
| tensio-actif B | - | - | - | - | 0,010 | **0,10** | 0,030 | **0,30** |

Les formulations E, F, G et H sont préparées comme suit : Pesée du PKHP-80 et du tensio-actif ; ajout du solvant ; homogénéisation durant 1 nuit sur un agitateur à rouleaux; ajout du BI7963 ; homogénéisation durant 1 heure sur l'agitateur à rouleaux.

Une première bande isolante 22A est ensuite formée par enduction de chacune des formulations E, F, G et H sur des électrodes inférieures 18A, 18B telles que décrites ci-dessus. Les enductions sont réalisées avec un applicateur automatique (AAF) de la société Erichsen selon les paramètres suivants: vitesse: 10 mm/s; fente: 50 µm ; volume : 600 µL.

On mesure la première tension de surface T_{S1} des formulations sur les électrodes inférieures, grâce à un tensiomètre Krüss K100. Les mesures de T_{S1} pour les différentes formulations sont présentées dans le tableau 2.

**Tableau 2**

| **T_{S1} (mN/m)** | | Valeur de γ_{S1} - 25 mN/m | Valeur de γ_{S1} - 15 mN/m |
|---|---|---|---|
| **Formulation E** | 17,1 | Entre 13 et 20 | Entre 23 et 30 |
| **Formulation F** | 15,3 | | |
| **Formulation G** | 7,5 | | |
| **Formulation H** | 12,8 | | |

Un séchage de 2 minutes à 120 °C en étuve est ensuite effectué. Des bandes isolantes solides dénommées E, F, G et H sont ainsi obtenues.

La deuxième énergie de surface γ_{S2} des bandes isolantes E, F, G et H est ensuite mesurée par le goniomètre, selon la méthode décrite ci-dessus pour la première énergie de surface. Les différentes énergies de surface ainsi mesurées sont présentées dans le tableau 3 de l'exemple 2 ci-après.

### Exemple 2 : formation de la première connexion électrique 17A

Une deuxième formulation liquide est obtenue pour la réalisation de la première connexion électrique 17A. La deuxième formulation liquide comprend un matériau conducteur de type encre à base d'argent.

Une couche de deuxième formulation liquide est ensuite enduite sur chacune des bandes isolantes E, F, G et H. On réalise une enduction de la deuxième formulation liquide avec l'applicateur automatique de film (AAF) de chez Erichsen. Le volume déposé et les fentes varient en fonction des essais (fentes testées 12,5 µm et 50 µm).

On mesure la deuxième tension de surface T_{S2} de la deuxième formulation liquide sur chacune des bandes isolantes E, F, G et H, grâce à un tensiomètre Krüss K100. Dans tous les cas, la deuxième tension de surface T_{S2} est comprise entre 21,5 et 21,9mN/m.

Les mesures de γ_{S2} pour les différentes bandes isolantes sont présentées dans le tableau 3 :

**Tableau 3**

| | **γ_{S2} (mN/m)** | Valeur de T_{S2} + 15 mN/m |
|---|---|---|
| bande isolante E | 39,64 | 36,5 |
| bande isolante F | 40,18 | |
| bande isolante G | 28,39 | |
| bande isolante H | 18,46 | |

### Conclusion

Les premières tensions de surface T_{S1} des formulations G et H ne sont pas comprises entre les valeurs (γ_{S1} - 25 mN/m) et (γ_{S1} - 15 mN/m). De même, les deuxièmes énergies de surface γ_{S2} des bandes isolantes G et H sont inférieures à la valeur (T_{S2} + 15 mN/m).

Les formulations G et H et les bandes isolantes issues de ces formulations présentent respectivement des tensions de surface et des énergies de surface trop faibles. La formation de la connexion électrique 17A sur une bande isolante 22A issue des formulations G et H conduit à une mauvaise homogénéité de la couche de matériau conducteur 52, ce qui peut provoquer une rupture de la connexion électrique entre les cellules photovoltaïques 16A et 16B.

Expérimentalement, la résistance électrique mesurée sur les électrodes 36, 18B, de part et d'autre de la bande isolante 22A recouverte par la connexion électrique 17A, est supérieure à 100 Ω. Cette résistance entraine une perte de la connexion électrique entre les deux cellules 16A et 16B. Le module photovoltaïque 10 ainsi obtenu n'est donc pas fonctionnel.

Au contraire, les formulations E et F et les bandes isolantes issues de ces formulations présentent respectivement des tensions de surface et des énergies de surface dans la gamme souhaitée. La formation de la connexion électrique 17A sur une bande isolante 22A issue des formulations E et F conduit à une couche homogène de matériau conducteur 52, donc à une bonne connexion électrique entre les cellules photovoltaïques 16A et 16B. Le module photovoltaïque 10 ainsi obtenu est fonctionnel.

## Revendications

1. Procédé de fabrication d'un module photovoltaïque (10), comprenant au moins deux cellules photovoltaïques (16A, 16B) connectées électriquement, le procédé comprenant les étapes suivantes :
- a) fourniture d'un substrat (12) électriquement isolant recouvert d'une couche d'un premier matériau électriquement conducteur (19) ; puis
- b) formation, sur ladite couche, d'au moins un sillon (20A) définissant une première (18A) et une deuxième (18B) électrodes inférieures, électriquement isolées l'une de l'autre par ledit sillon ; puis
- c) formation, sur chacune desdites électrodes inférieures, d'un empilement (34) comprenant au moins : une électrode supérieure (36) formée d'une couche d'un deuxième matériau électriquement conducteur (40) ; et une couche (38) d'un matériau photo-actif disposée entre les électrodes inférieure et supérieure,
chacune des première et deuxième électrodes inférieures formant respectivement une première (16A) et une deuxième (16B) cellules photovoltaïques avec l'empilement correspondant,
- d) formation d'une connexion électrique (17A) entre l'électrode supérieure de la première cellule photovoltaïque et la deuxième électrode inférieure ;
le procédé étant **caractérisé en ce qu'**il comprend les étapes suivantes, entre les étapes b) et c) :
- e) formation d'une première bande électriquement isolante (22A) dans le sillon (20A) et par-dessus ledit sillon, ladite bande formant un relief par rapport aux première et deuxième électrodes inférieures ; et
- f) formation d'une deuxième bande électriquement isolante (24B) sur la deuxième électrode inférieure, lesdites première et deuxième bandes électriquement isolantes étant sensiblement parallèles et délimitant une zone inactive (28B) sur ladite deuxième électrode inférieure ;et **en ce que** l'empilement formé à l'étape c) sur la deuxième cellule photovoltaïque est disposé en dehors de ladite zone inactive.

2. Procédé selon la revendication 1, dans lequel une largeur (32) de la zone inactive (28B) est comprise entre 0,1 mm et 2 mm.

3. Procédé selon la revendication 1 ou la revendication 2, dans lequel au moins l'une des couches (36, 38) de deuxième matériau électriquement conducteur et de matériau photo-actif est formée par une technique d'enduction ou d'impression au déroulé par voie humide, préférentiellement choisie parmi le slot-die, l'héliogravure et la flexographie.

4. Procédé selon l'une des revendications précédentes, dans lequel l'électrode supérieure (36) et la connexion électrique (17A, 17B) sont formées d'un matériau électriquement conducteur (40) transparent à la lumière visible.

5. Procédé selon l'une des revendications précédentes, dans lequel :
- au moins la première bande électriquement isolante (22A, 22B) est formée par dépôt, sur le sillon (20A, 20B) et sur le premier matériau électriquement conducteur, d'une première formulation liquide de matériau isolant, suivi d'un passage à l'état solide de ladite première formulation ;
- la couche du premier matériau électriquement conducteur (19) recouvrant le substrat (12) présente une première énergie de surface (γ_{S1}) ;
- le dépôt de la première formulation liquide crée une première interface (60) avec ledit premier matériau électriquement conducteur, la première tension de surface (T_{S1}) de ladite première interface étant inférieure à ladite première énergie de surface (γ_{S1}) ;
une différence entre ladite première énergie de surface et ladite première tension de surface étant préférentiellement comprise entre 0,015 N.m⁻¹ et 0,025 N.m⁻¹.

6. Procédé selon la revendication 5, dans lequel la première formulation liquide de matériau isolant comprend au moins un polymère et au moins un tensio-actif,
l'au moins un polymère étant préférentiellement préparé à base de composés choisis parmi les aminés, les acrylates, les époxydes, les uréthanes et leurs mélanges, et
l'au moins un tensio-actif étant préférentiellement un composé fluoré.

7. Procédé selon l'une des revendications précédentes, dans lequel l'étape d) comprend le dépôt d'une couche d'un troisième matériau électriquement conducteur (52) entre l'électrode supérieure (36) de la première cellule photovoltaïque (16A, 16B) et la deuxième électrode inférieure de la deuxième cellule photovoltaïque (16B, 16C), par-dessus la première bande électriquement isolante (22A, 22B).

8. Procédé selon la revendication 7, dans lequel :
- la première bande électriquement isolante (22A, 22B) présente une deuxième énergie de surface (γ_{S2}) ;
- la couche de troisième matériau électriquement conducteur est formée par dépôt d'une deuxième formulation liquide, créant une deuxième interface (62) avec ladite première bande électriquement isolante, une deuxième tension de surface (T_{S2}) de ladite deuxième interface étant inférieure à ladite deuxième énergie de surface (γ_{S2}) ;
une différence entre ladite deuxième énergie de surface et ladite deuxième tension de surface étant préférentiellement supérieure à 0,015 N.m⁻¹.

9. Procédé selon l'une des revendications 7 ou 8, dans lequel l'étape d) est réalisée simultanément au dépôt de la couche du deuxième matériau électriquement conducteur (36) de l'étape c), le troisième matériau électriquement conducteur (52) étant identique audit deuxième matériau électriquement conducteur (40).

10. Procédé selon l'une des revendications 7 à 9, dans lequel une épaisseur (54) de la couche de troisième matériau électriquement conducteur est inférieure à 1 µm et préférentiellement inférieure à 600 nm.

11. Module photovoltaïque (10) comprenant au moins deux cellules photovoltaïques (16A, 16B) connectées électriquement, ledit module comportant :
- un substrat (12) électriquement isolant ;
- une couche d'un premier matériau électriquement conducteur (19) recouvrant ledit substrat, ladite couche comprenant un sillon (20A) définissant une première (18A) et une deuxième (18B) électrodes inférieures, électriquement isolées l'une de l'autre par ledit sillon ;
- un empilement (34) disposé sur chacune desdites électrodes inférieures, ledit empilement comprenant au moins : une électrode supérieure (36) formée d'une couche d'un deuxième matériau électriquement conducteur (40) ; et une couche (38) d'un matériau photo-actif disposée entre les électrodes inférieure et supérieure,
chacune des première et deuxième électrodes inférieures formant respectivement une première (16A) et une deuxième (16B) cellules photovoltaïques avec l'empilement correspondant ;
- une première bande électriquement isolante (22A) disposée dans le sillon (20A) et par-dessus ledit sillon, ladite bande formant un relief par rapport aux première et deuxième électrodes inférieures ;
- une deuxième bande électriquement isolante (24B) disposée sur la deuxième électrode inférieure, les première et deuxième bandes électriquement isolantes étant sensiblement parallèles et délimitant une zone inactive (28B) sur la deuxième électrode inférieure ; l'empilement de la deuxième cellule photovoltaïque étant disposé en dehors de ladite zone inactive ; et
- une connexion électrique (17A) entre l'électrode supérieure de la première cellule photovoltaïque et la deuxième électrode inférieure, ladite connexion électrique comprenant une couche d'un troisième matériau électriquement conducteur (52), disposée entre l'électrode supérieure (36) de la première cellule photovoltaïque (16A, 16B) et la deuxième électrode inférieure de la deuxième cellule photovoltaïque (16B, 16C), par-dessus la première bande électriquement isolante (22A, 22B),
le module étant **caractérisé en ce que** une épaisseur (54) de la couche de troisième matériau électriquement conducteur étant inférieure à 5 µm ; et ledit module photovoltaïque étant issu d'un procédé selon l'une des revendications 1 à 10, au moins la première bande électriquement isolante (22A) étant formée par dépôt, sur le sillon et sur le premier matériau électriquement conducteur, d'une première formulation liquide de matériau isolant, suivi d'un passage à l'état solide de ladite première formulation.

12. Module photovoltaïque selon la revendication 11, dans lequel un ratio entre la somme d'aires des empilements (34) comprenant une couche de matériau photo-actif et une aire totale du substrat (12) est supérieur à 80% et préférentiellement supérieur à 85%.

13. Module photovoltaïque selon la revendication 11 ou la revendication 12, issu d'un procédé selon la revendication 10, dans lequel l'épaisseur (54) de la couche de troisième matériau électriquement conducteur est inférieure à 1 µm.

14. Module photovoltaïque selon l'une des revendications 11 à 13, dans lequel le troisième matériau électriquement conducteur (52) est identique au deuxième matériau électriquement conducteur (40).

## Patentansprüche

1. Verfahren zur Herstellung eines Photovoltaik-Moduls (10), welches mindestens zwei Photovoltaik-Zellen (16A, 16B), welche elektrisch verbunden sind, aufweist, wobei das Verfahren die folgenden Schritte aufweist:
- a) Bereitstellen eines elektrisch isolierenden Substrats (12), welches mit einer Schicht eines ersten elektrisch leitfähigen Materials (19) bedeckt ist, dann
- b) Ausbilden, auf der Schicht, von mindestens einem Graben (20A), welcher eine erste (18A) und eine zweite (18B) untere Elektrode definiert, welche durch den Graben (20A) voneinander elektrisch isoliert sind, dann
- c) Ausbilden, auf jeder der unteren Elektroden, eines Stapels (34), welcher aufweist mindestens: eine obere Elektrode (36), welche aus einer Schicht eines zweiten elektrisch leitfähigen Materials (40) gebildet ist, und eine Schicht (38) aus einem photoaktiven Material, welche zwischen den unteren und oberen Elektroden angeordnet ist,
wobei jede von der ersten und der zweiten unteren Elektrode jeweils eine erste (16a) und eine zweite (16B) Photovoltaik-Zelle mit dem korrespondierenden Stapel bildet,
- d) Ausbilden einer elektrischen Verbindung (17A) zwischen der oberen Elektrode der ersten Photovoltaik-Zelle und der zweiten unteren Elektrode,
wobei das Verfahren **dadurch gekennzeichnet ist, dass** es die folgenden Schritte zwischen den Schritten b) und c) aufweist:
- e) Ausbilden eines ersten elektrisch isolierenden Bands (22A) in dem Graben (20A) und über den Graben hinweg, wobei das Band eine Erhebung bezüglich der ersten und der zweiten unteren Elektrode bildet, und
- f) Ausbilden eines zweiten elektrisch isolierenden Bands (24B) auf der zweiten unteren Elektrode, wobei das erste und das zweite elektrisch isolierende Band im Wesentlichen parallel sind und einen inaktiven Bereich (28B) auf der zweiten unteren Elektrode begrenzen, und dadurch, dass der in Schritt c) ausgebildete Stapel auf der zweiten Photovoltaik-Zelle außerhalb des inaktiven Bereichs (28B) angeordnet ist.

2. Verfahren gemäß dem Anspruch 1, wobei eine Breite (32) des inaktiven Bereichs (28B) zwischen 0,1 mm und 2 mm beträgt.

3. Verfahren gemäß dem Anspruch 1 oder dem Anspruch 2, wobei mindestens eine der Schichten (36, 38) des zweiten elektrisch leitfähigen Materials und des photoaktiven Materials durch eine Beschichtungstechnik oder Drucktechnik mit Nassverfahrensablauf ausgebildet wird, vorzugsweise ausgewählt aus der Schlitzdüsentechnik, dem Tiefdruck und dem Flexodruck.

4. Verfahren gemäß irgendeinem der vorhergehenden Ansprüche, wobei die obere Elektrode (36) und die elektrische Verbindung (17A, 17B) aus einem elektrisch leitfähigen Material (40), welches für sichtbares Licht transparent ist, gebildet werden.

5. Verfahren gemäß irgendeinem der vorhergehenden Ansprüche, wobei:
- mindestens das erste elektrisch isolierende Band (22A, 22B) gebildet wird durch Ablagern, auf dem Graben (20A, 20B) und auf dem ersten elektrisch leitfähigen Material, einer ersten flüssigen Formulierung von isolierendem Material, gefolgt durch einen Übergang der ersten Formulierung in den festen Zustand,
- die Schicht des ersten elektrisch leitfähigen Materials (19), welche das Substrat (12) bedeckt, eine erste Oberflächenenergie (ys1) aufweist,
- das Ablagern der ersten flüssigen Formulierung eine erste Grenzfläche (60) mit dem ersten elektrisch leitfähigen Material erzeugt, wobei die erste Oberflächenspannung (Tₛ₁) der ersten Grenzfläche kleiner als die erste Oberflächenenergie (ys1) ist,
wobei eine Differenz zwischen der ersten Oberflächenenergie und der ersten Oberflächenspannung vorzugsweise zwischen 0,015 N.m⁻¹ und 0,025 N.m⁻¹ liegt.

6. Verfahren gemäß dem Anspruch 5, wobei die erste flüssige Formulierung von isolierendem Material mindestens ein Polymer und mindestens ein Tensid aufweist,
wobei das mindestens eine Polymer vorzugsweise hergestellt ist auf Grundlage von Verbindungen, welche ausgewählt sind aus den Aminen, den Acrylaten, den Epoxiden, den Urethanen und deren Mischungen, und
wobei das mindestens eine Tensid vorzugsweise eine Fluorverbindung ist.

7. Verfahren gemäß irgendeinem der vorhergehenden Ansprüche, wobei der Schritt d) das Ablagern einer Schicht eines dritten elektrisch leitfähigen Materials (52) zwischen der oberen Elektrode (36) der ersten Photovoltaik-Zelle (16A, 16B) und der zweiten unteren Elektrode der zweiten Photovoltaik-Zelle (16B, 16C) über das erste elektrisch isolierende Band (22A, 22B) hinweg aufweist.

8. Verfahren gemäß dem Anspruch 7, wobei:
- das erste elektrisch isolierende Band (22A, 22B) eine zweite Oberflächenenergie (ys2) aufweist,
- wobei die Schicht des dritten elektrisch leitfähigen Material ausgebildet wird durch Ablagern einer zweiten flüssigen Formulierung, welche eine zweite Grenzfläche (62) mit dem ersten elektrisch isolierenden Band erzeugt, wobei eine zweite Oberflächenspannung (Tₛ₂) der zweiten Grenzfläche kleiner als die zweite Oberflächenenergie (ys2) ist,
wobei eine Differenz zwischen der zweiten Oberflächenenergie und der zweiten Oberflächenspannung vorzugsweise größer als 0,015 N.m⁻¹ ist.

9. Verfahren gemäß dem Anspruch 7 oder 8, wobei der Schritt d) umgesetzt wird gleichzeitig zur Ablagerung der Schicht des zweiten elektrisch leitfähigen Material (36) des Schritts (c), wobei das dritte elektrisch leitfähige Material (52) identisch mit dem zweiten elektrisch leitfähigen Material (40) ist.

10. Verfahren gemäß irgendeinem der Ansprüche 7 bis 9, wobei eine Dicke (54) der Schicht des dritten elektrisch leitfähigen Materials kleiner als 1 und vorzugsweise kleiner als 600 nm ist.

11. Photovoltaik-Modul (10), welches mindestens zwei Photovoltaik-Zellen (16A, 16B), welche elektrisch verbunden sind, aufweist, wobei das Modul aufweist:
- ein elektrisch isolierendes Substrat (12),
- eine Schicht eines ersten elektrisch leitfähigen Materials (19), welches das Substrat bedeckt, wobei die Schicht einen Graben (20A) aufweist, welcher eine erste (18A) und eine zweite (18B) untere Elektrode definiert, welche durch den Graben (20A) voneinander elektrisch isoliert sind,
- einen Stapel (34), welcher auf jeder der unteren Elektroden angeordnet ist, wobei der Stapel aufweist mindestens: eine obere Elektrode (36), welche aus einer Schicht eines zweiten elektrisch leitfähigen Materials (40) gebildet ist, und eine Schicht (38) aus einem photoaktiven Material, welche zwischen den unteren und oberen Elektroden angeordnet ist,
wobei jede von der ersten und der zweiten unteren Elektrode jeweils eine erste (16a) und eine zweite (16B) Photovoltaik-Zelle mit dem korrespondierenden Stapel bildet,
- ein erstes elektrisch isolierendes Band (22A), welches in dem Graben (20A) und über den Graben hinweg angeordnet ist, wobei das Band eine Erhebung bezüglich der ersten und der zweiten unteren Elektrode bildet,
- ein zweites elektrisch isolierendes Band (24B), welches auf der zweiten unteren Elektrode angeordnet ist, wobei das erste und das zweite elektrisch isolierende Band im Wesentlichen parallel sind und einen inaktiven Bereich (28B) auf der zweiten unteren Elektrode begrenzen, und wobei der Stapel der zweiten Photovoltaik-Zelle außerhalb des inaktiven Bereichs (28B) angeordnet ist, und
- eine elektrische Verbindung (17A) zwischen der oberen Elektrode der ersten Photovoltaik-Zelle und der zweiten unteren Elektrode, wobei die elektrische Verbindung (17A) aufweist eine Schicht eines drittem elektrisch leitfähigen Materials (52), welche zwischen der oberen Elektrode (36) der ersten Photovoltaik-Zelle (16A, 16B) und der zweiten unteren Elektrode der zweiten Photovoltaik-Zelle (16B, 16C) über das erste elektrisch isolierende Band (22A, 22B) hinweg angeordnet ist,
wobei das Modul **gekennzeichnet ist dadurch**, dass
eine Dicke (54) der Schicht des dritten elektrisch leitfähigen Materials kleiner als 5 ist, und
wobei das Photovoltaik-Modul aus einem Verfahren gemäß irgendeinem der Ansprüche 1 bis 10 hervorgeht, wobei zumindest das erste elektrisch isolierende Band (22A) gebildet ist **durch** Ablagern, auf dem Graben und auf dem ersten elektrisch leitfähigen Material, einer ersten flüssigen Formulierung von isolierendem Material, gefolgt **durch** einen Übergang der ersten Formulierung in den festen Zustand.

12. Photovoltaik-Modul gemäß dem Anspruch 11, wobei ein Verhältnis zwischen der Summe der Flächen der Stapel (34), welche eine Schicht aus photoaktiven Material aufweist, und einem Gesamtfläche des Substrats (12) größer als 80 % und vorzugsweise größer als 85 % ist.

13. Photovoltaik-Modul gemäß dem Anspruch 11 oder dem Anspruch 12, welches aus einem Verfahren nach Anspruch 10 hervorgeht, wobei die Dicke (54) der Schicht des dritten elektrisch leitfähigen Materials kleiner als 1 ist.

14. Photovoltaik-Modul gemäß irgendeinem der Ansprüche 11 bis 13 , wobei das dritte elektrisch leitfähige Material (52) identisch mit dem zweiten elektrisch leitfähigen Material (40) ist.

## Claims

1. A method for manufacturing a photovoltaic module (10), comprising at least two electrically connected photovoltaic cells (16A, 16B), the method comprising the following steps:
- a) providing an electrically insulating substrate (12) covered with a layer of a first electrically conducting material (19); then
- b) forming, on said layer, at least one furrow (20A) defining first (18A) and second (18B) lower electrodes, electrically isolated from one another by said furrow; then
- c) forming, on each of said lower electrodes, a stack (34) comprising at least: an upper electrode (36) formed by a layer of a second electrically conducting material (40); and a layer (38) of a photo-active material positioned between the lower and upper electrodes,
each of the first and second lower electrodes respectively forming a first (16A) and second (16B) photovoltaic cell with the corresponding stack,
- d) forming an electrical connection (17A) between the upper electrode of the first photovoltaic cell and the second lower electrode;
the method being **characterized in that** it comprises the following steps, between steps b) and c):
- e) forming a first electrically insulating strip (22A) in the furrow (20A) and above said furrow, said strip forming a relief relative to the first and second lower electrodes; and
- f) forming a second electrically insulating strip (24B) on the second lower electrode, said first and second electrically insulating strips being substantially parallel and delimiting an inactive area (28B) on said second lower electrode;
**in that** the stack formed in step c) on the second photovoltaic cell is positioned outside the inactive area.

2. The method according to claim 1, wherein a width (32) of the inactive area (28B) is comprised between 0.1 mm and 2 mm.

3. The method according to claim 1 or claim 2, wherein at least one of the layers (36, 38) of second electrically conducting material and photo-active material is formed by a coating or printing technique using a continuous wet method, preferably chosen from among slot-die, photogravure and flexography.

4. The method according to one of the preceding claims, wherein the upper electrode (36) and the electrical connection (17A, 17B) are formed from an electrically conducting material (40) transparent to visible light.

5. The method according to one of the preceding claims, wherein:
- at least the first electrically insulating strip (22A, 22B) is formed by deposition, on the furrow (20A, 20B) and on the first electrically conducting material, of a first liquid formulation of insulating material, followed by a passage to the solid state of said first formulation;
- the layer of the first electrically conducting material (19) covering the substrate (12) has a first surface energy (γ_{S1});
- the deposition of the first liquid formulation creates a first interface (60) with said first electrically conducting material, the first surface tension (T_{S1}) of said first interface being lower than said first surface energy (γ_{S1});
a difference between said first surface energy and said first surface tension preferably being comprised between 0.015 N.m⁻¹ and 0.025 N.m⁻¹.

6. The method according to claim 5, wherein the first liquid formulation of insulating material comprises at least one polymer and at least one surfactant,
the at least one polymer preferably being prepared with a base of compounds chosen from among amines, acrylates, epoxides, urethanes and mixtures thereof, and
the at least one surfactant preferably being a fluorinated compound.

7. The method according to one of the preceding claims, wherein step d) comprises depositing a layer of a third electrically conducting material (52) between the upper electrode (36) of the first photovoltaic cell (16A, 16B) and the second lower electrode of the second photovoltaic cell (16B, 16C), above the first electrically insulating strip (22A, 22B).

8. The method according to claim 7, wherein:
- the first electrically insulating strip (22A, 22B) has a second surface energy (γ_{S2});
- the third layer of electrically conducting material is formed by depositing a second liquid formulation, creating a second interface (62) with said first electrically insulating strip, a second surface tension (T_{S2}) of said second interface being lower than said second surface energy (γ_{S2});
a difference between said second surface energy and said second surface tension preferably being greater than 0.015 N.m⁻¹.

9. The method according to one of claim 7 or claim 8, wherein step d) is carried out at the same time as the deposition of the layer of the second electrically conducting material (36) of step c), the third electrically conducting material (52) being identical to said second electrically conducting material (40).

10. The method according to one of claims 7 to 9, wherein a thickness (54) of the layer of third electrically conducting material is smaller than 1 µm and preferably smaller than 600 nm.

11. A photovoltaic module (10) including at least two electrically connected photovoltaic cells (16A, 16B), said module comprising :
- an electrically insulating substrate (12) ;
- a layer of a first electrically conducting material (19) covering said substrate, said layer comprising a furrow (20A) defining a first (18A) and a second (18B) lower electrodes, electrically isolated from one another by said furrow;
- a stack (34) formed on each of said lower electrodes, said stack comprising at least : an upper electrode (36) formed by a layer of a second electrically conducting material (40); and a layer (38) of a photo-active material positioned between the lower and upper electrodes,
each of the first and second lower electrodes respectively forming a first (16A) and second (16B) photovoltaic cell with the corresponding stack ;
- a first electrically insulating strip (22A) formed in the furrow (20A) and above said furrow, said strip forming a relief relative to the first and second lower electrodes ;
- a second electrically insulating strip (24B) formed on the second lower electrode, the first and second electrically insulating strips being substantially parallel and delimiting an inactive area (28B) on said second lower electrode; the stack formed on the second photovoltaic cell being positioned outside the inactive area ; and
- an electrical connection (17A) between the upper electrode of the first photovoltaic cell and the second lower electrode; said electrical connection comprising a layer of a third electrically conducting material (52), formed between the upper electrode (36) of the first photovoltaic cell (16A, 16B) and the second lower electrode of the second photovoltaic cell (16B, 16C), above the first electrically insulating strip (22A, 22B) ;
the module being **characterized in that**
a thickness (54) of the layer of the third electrically conducting material being less than 5 µm ; and
said photovoltaic module being derived from a method according to one of claims 1 to 10, at least the first electrically insulating strip (22A) being formed by deposition, on the furrow and on the first electrically conducting material, of a first liquid formulation of insulating material, followed by a passage to the solid state of said first formulation.

12. The photovoltaic module according to claim 11, wherein a ratio between the sum of areas of the stacks (34) comprising a layer of photo-active material and a total area of the substrate (12) is greater than 80%, and preferably greater than 85%.

13. The photovoltaic module according to claim 11 or claim 12, derived from a method according to claim 10, wherein the thickness (54) of the layer of the third electrically conducting material is less than 1 µm.

14. The photovoltaic module according to one of claims 11 to 13, wherein the third electrically conducting material (52) is identical to said second electrically conducting material (40).
